# DEMANDE DE BREVET EUROPEEN

(11) **EP 1 032 001 A1**
(43) Date de publication de la demande: **30.08.2000**
(21) Numéro de dépôt: 00420039.0
(22) Date de dépôt: 22.02.2000
(51) Int. Cl.: H01F 17/00, H01L 23/64

(54) **Composant inductif, tranformateur intégré, notamment destinés à être incorporés dans un circuit radiofréquence, et circuit intégré associé avec un tel composant inductif ou transformateur intégré**

(30) Priorité: 26.02.1999 FR 9902658
(71) Demandeur: Memscap, 38330 Saint Ismier (FR); Planhead-Silmag Phs, 75008 Paris (FR)
(72) Inventeur: Basteres, Laurent, 38100 Grenoble (FR); Mhani, Ahmed, 38100 Grenoble (FR); Valentin, François, 38113 Veurey Voroize (FR); Karam, Jean-Michel, 38000 Grenoble (FR)
(74) Mandataire: Palix, Stéphane

(57) **Abrégé**

Composant inductif (1), notamment destiné à être incorporé dans un circuit radiofréquence, comprenant :
- une couche de substrat (2) ;
- une inductance plane formée d'un ruban métallique (3) enroulé en spirale ; caractérisé en ce que
- la couche de substrat (2) est réalisée en quartz ;
le ruban métallique (3) est réalisé en cuivre, et présente une épaisseur (E₃) supérieure à 10 microns.

## Description

### Domaine Technique

L'invention concerne le domaine de la micro-électronique et des micro-systèmes. Elle vise plus précisément une nouvelle conception de composants inductifs ou de transformateurs intégrés destinés à être associés à des circuits intégrés, tels qu'utilisés notamment dans le domaine des radiofréquences.

Elle vise plus précisément obtenir des inductances présentant un meilleur facteur de qualité dès les basses fréquences, et assurant un fonctionnement à des fréquences plus élevées qu'avec des inductances actuellement obtenues.

### Techniques antérieures

Comme on le sait, les circuits intégrés sont de plus en plus utilisés dans les techniques des micro-ondes et des radiofréquences.

Dans ces applications, il est important de pouvoir utiliser les circuits oscillants accordés, constitués par un ensemble capacité inductance. Or, ces circuits doivent être réalisés dans des volumes de plus en plus réduits. En outre, ils doivent fonctionner à des fréquences de plus en plus élevées.

Enfin, la consommation électrique de tels composants devient un paramètre critique, par exemple dans les téléphones portables cellulaires, car cette consommation influe directement sur l'autonomie de ces appareils.

Ainsi, il est demandé aux composants passifs constituant les filtres utilisés dans les systèmes radiofréquences, notamment les inductances, d'occuper une surface aussi faible que possible à l'intérieur des circuits intégrés, d'avoir une valeur de cette inductance aussi élevée que possible, et d'induire une consommation électrique aussi faible que possible.

En outre, on sait que les inductances implantées à l'intérieur de circuits intégrés en matériau semi-conducteurs subissent l'influence de capacités parasites constituées par les différentes zones de substrat localisées au voisinage des inductances.

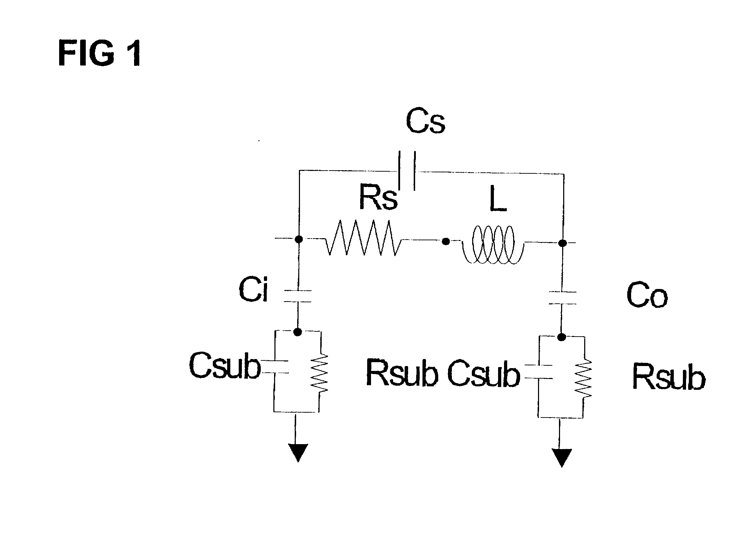

On a représenté en figure 1 un schéma équivalent à une inductance implantée dans une puce de circuit intégré.

Ainsi, une telle inductance présente un schéma équivalent dans lequel, à cette inductance proprement dite (L), s'ajoutent les différents composants parasites écartant cette inductance de son comportement idéal.

Ainsi, une inductance présente une résistance (Rₛ) correspondant à celle du métal qui la compose. En outre, cette inductance présente différentes capacités (Cᵢ et Cₒ), qui sont des capacités parasites résultant de la présence de la couche d'oxyde déposée au dessus du substrat . En outre, cette inductance comporte en série avec lesdites capacités Cₒ et Cᵢ , une capacité C_{sub} et une résistance R_{sub} en parallèle correspondant à l'influence du substrat semi-conducteur situé entre ladite couche d'oxyde et le plan de masse.

Par ailleurs, une certaine capacité parasite existe entre les différentes spires constituant l'inductance, et qui est modélisée dans le schéma équivalent de la figure 1 par la capacité (Cₛ).

Le Demandeur, dans la demande de brevet français FR 98.08434, non encore publiée à la date de dépôt de la présente demande, a décrit une solution permettant de réaliser de telles inductances sur un substrat semi-conducteur, en adoptant une disposition permettant de fortement diminuer la valeur de la capacité parasite (Cₛ) existant entre spires. Grâce à une telle solution, il est possible d'utiliser une telle inductance à des fréquences plus élevées tout en conservant un comportement satisfaisant.

On rappelle que la fréquence optimale de fonctionnement est déterminée comme étant celle où le facteur de qualité est maximum. Le facteur de qualité est déterminé de façon connue par le rapport entre la partie imaginaire ou réactance et la partie réelle de l'inductance d'entrée correspondant au modèle illustré à la figure 1.

La solution décrite dans le document précité, bien que satisfaisante, ne permet pas d'améliorer de façon notable le facteur de qualité dans les plages de fréquence basses, c'est-à-dire situées en-dessous de la moitié de la fréquence optimale, qui est typiquement dans les applications radiofréquences de l'invention, proches de quelques gigahertz.

En effet, dans cette gamme de fréquences, le comportement de l'inductance est fortement dépendant de la valeur de la résistance (Rₛ), qui correspond à la résistance électrique du ruban métallique constituant l'inductance proprement dite.

Or, toutes les inductances réalisées dans des circuits même intégrés sont aujourd'hui réalisées en aluminium, et présentent des dimensions faibles, et surtout une épaisseur très faible, ce qui se traduit par une résistance électrique élevée.

Ainsi, un des problèmes que se propose de résoudre l'invention est celui de l'influence néfaste de la résistance globale de l'enroulement formant inductance.

### Exposé de l'invention

L'invention concerne donc un composant inductif, notamment :
- une couche de substrat ;
- une inductance plane formée d'un ruban métallique enroulé en spirale.

Le composant inductif conforme à l'invention, se caractérise en ce que d'une part, la couche de substrat est réalisée en quartz, et d'autre part, en ce que le ruban métallique est réalisé en cuivre, et présente une épaisseur supérieure à 10 microns.

De la sorte, on diminue très fortement la valeur de la résistance de l'enroulement en utilisant un matériau conducteur beaucoup moins résistif que l'aluminium utilisé dans les techniques antérieures.

En outre, les paramètres dimensionnels choisis, et notamment l'épaisseur du ruban qui constitue les spires diminuent également très fortement la valeur globale de la résistance de l'enroulement.

Cette diminution de la résistance se fait en conservant une valeur de capacité parasite (Cₛ), extrêmement minime grâce à l'implantation du ruban métallique sur un substrat en quartz, dont les propriétés diélectriques sont assez proches de celles de l'air.

On a observé que grâce aux caractéristiques de l'inductance conforme à l'invention, le facteur de qualité était dix fois supérieur à celui observé avec une inductance de même valeur, mais réalisé conformément à l'Art antérieur.

A titre d'exemple, pour une inductance de l'ordre de 5 nanohenrics (nH), et pour une valeur typique de fréquence de 1,8 gigahertz (GHz), le facteur de qualité est de l'ordre de 40, alors qu'avec les technologies antérieures, il avoisinait 4.

En pratique, on a constaté que les résultats étaient très satisfaisants lorsque l'épaisseur du ruban métallique était voisine de 30 microns.

Conformément à une caractéristique de l'invention, l'espace entre les faces en regard de deux spires adjacentes, est exempt de matière.

De la sorte, la présence d'air, de très faible permitivité électrique, limite fortement les capacités parasites existant entre spires, et dont on a vu qu'elles jouaient un rôle défavorable pour l'utilisation optimale des inductances intégrées.

Dans une forme de réalisation, le composant inductif conforme à l'invention comporte en outre une couche de polyimide interposée entre l'inductance et le substrat de quartz, et à l'intérieur de laquelle chemine le segment du ruban reliant le centre de la spirale, et l'extrémité du ruban formant borne de connexion.

Avantageusement en pratique, le ruban métallique est recouvert d'une couche d'or, sur ses faces autres que celles en contact avec le substrat ou la couche de polyimide.

Ainsi, on s'affranchit des risques d'oxydation inhérents au fonctionnement du composant conforme à l'invention dans un environnement chimiquement agressif, tel que notamment l'atmosphère humide, voire maritime, en protégeant le ruban conducteur des phénomènes d'oxydation qui dégraderaient la résistance globale du ruban.

Les aspects de l'invention précités peuvent également s'appliquer à la réalisation de transformateurs intégrés. Ainsi, un tel transformateur inclut deux inductances planes conformes à l'invention, formées par deux rubans métalliques enroulés en spirales, lesdites spirales s'enroulant l'une dans l'autre de sorte que les spires de l'une des inductances sont positionnées entre les spires de l'autre inductance.

Pour obtenir des valeurs d'inductances importantes, tout en conservant un facteur de qualité satisfaisant, avantageusement en pratique, le ruban est enroulé en deux spirales en série, les deux spirales étant parallèles l'une par rapport à l'autre, la spirale la plus proche du substrat étant noyée dans une couche de polyimide.

De la sorte, grâce aux phénomènes de couplage magnétique, la valeur de l'inductance est supérieur au double de la valeur de l'inductance formée d'une seule spirale. L'encombrement général d'une telle inductance est donc réduit. En outre, pour une valeur d'inductance donnée, on utilise deux spirales ayant chacune une résistance inférieure à la moitié de celle d'une inductance unique, ce qui s'avère avantageux sur le facteur de qualité.

Dans une forme particulière, destinée à des applications en milieux particulièrement agressifs, la couche de polyimide dans laquelle est noyée la seconde spirale peut être recouverte d'une couche barrière en silice. De la sorte, la durée de vie d'un tel composant peut être prolongée.

Dans une forme particulière, l'inductance conforme à l'invention est telle que les deux extrémités du ruban forment des bornes de connexion sur lesquelles sont montés des éléments entretoises ou "bumps" présentant une hauteur voisine de l'épaisseur du ruban métallique.

De la sorte, une telle inductance, ou sa transposition au transformateur, présente des éléments facilitant la mise en place sur un circuit intégré.

L'invention concerne également un circuit intégré associé à un composant inductif ou un transformateur intégré précité.

Selon une caractéristique de l'invention, un tel circuit intégré comprend des plots de connexion du composant inductif ou du transformateur intégré, et il se caractérise en ce que :
- le substrat utilisé est réalisé en quartz ;
- les rubans métalliques sont réalisées en cuivre, et présentent une épaisseur supérieure à 10 microns.

Autrement dit, on assure le montage du composant inductif ou du transformateur par une technique connue sous l'appellation de "flip-chip".

Avantageusement en pratique, on choisit les éléments entretoises, communément appelés "bumps", de telle sorte qu'ils aient une hauteur voisine de l'épaisseur du ruban du composant inductif.

De la sorte, le ruban formant inductance est séparé du substrat semi-conducteur du circuit intégré d'une distance assurant une stabilité mécanique du composant inductif sur le circuit intégré, tout en limitant l'influence de la conductivité parasite du substrat semi-conducteur sur le comportement de l'inductance.

En effet, on a observé que si la hauteur des éléments entretoises est trop importante, typiquement supérieure à l'épaisseur du ruban, alors il en résulte un risque d'instabilité mécanique qui peut se traduire dans le cas de chocs, par la rupture de la connexion entre le circuit intégré et l'inductance.

A l'inverse, lorsque la distance entre le substrat semi-conducteur du circuit intégré et l'inductance est trop faible, on observe des phénomènes de pertes électriques à travers le semi-conducteur qui diminuent les performances de cette dernière.

Ainsi, en pratique, on obtient de bons résultats avec des entretoises ou "bumps" de 30 microns pour une épaisseur de ruban de l'ordre de 30 microns.

Avantageusement en pratique, pour améliorer encore la stabilité du composant inductif monté sur le circuit intégré, les éléments entretoises ont une forme cylindrique, qui préférentiellement, a un diamètre voisin de trois fois sa hauteur.

### Description sommaire des figures

La manière de réaliser l'invention, ainsi que les avantages qui en découlent ressortiront bien de la description des modes de réalisation qui suivent, à l'appui des figures annexées dans lesquelles :

La figure 1 est un schéma électrique, modélisant le comportement d'une inductance montée sur un substrat.

La figure 2 est une vue de dessus d'un composant inductif conforme à l'invention.

La figure 3 est une vue en coupe transversale d'un composant conforme à l'invention, utilisant un ruban formant une spirale unique.

Les figures 4 et 5 sont des vues en coupe partielles illustrant des modes de réalisation dans lesquels l'inductance est formée par deux spirales parallèles.

La figure 6 est une vue de dessus d'un transformateur intégré conforme à l'invention incluant deux enroulements.

La figure 7 est une vue en coupe transversale d'un transformateur réalisé conformément à l'invention.

La figure 8 est un schéma explicatif simplifié montrant l'association d'un composant inductif conforme à l'invention sur un circuit intégré.

La figure 9 est la reproduction d'une photo prise au microscope électronique d'un ruban métallique utilisé dans un composant inductif conforme à l'invention.

Comme déjà dit, l'invention concerne en premier lieu un composant inductif destiné à être utilisé en association avec un circuit intégré, dans des applications radiofréquences ou micro-ondes.

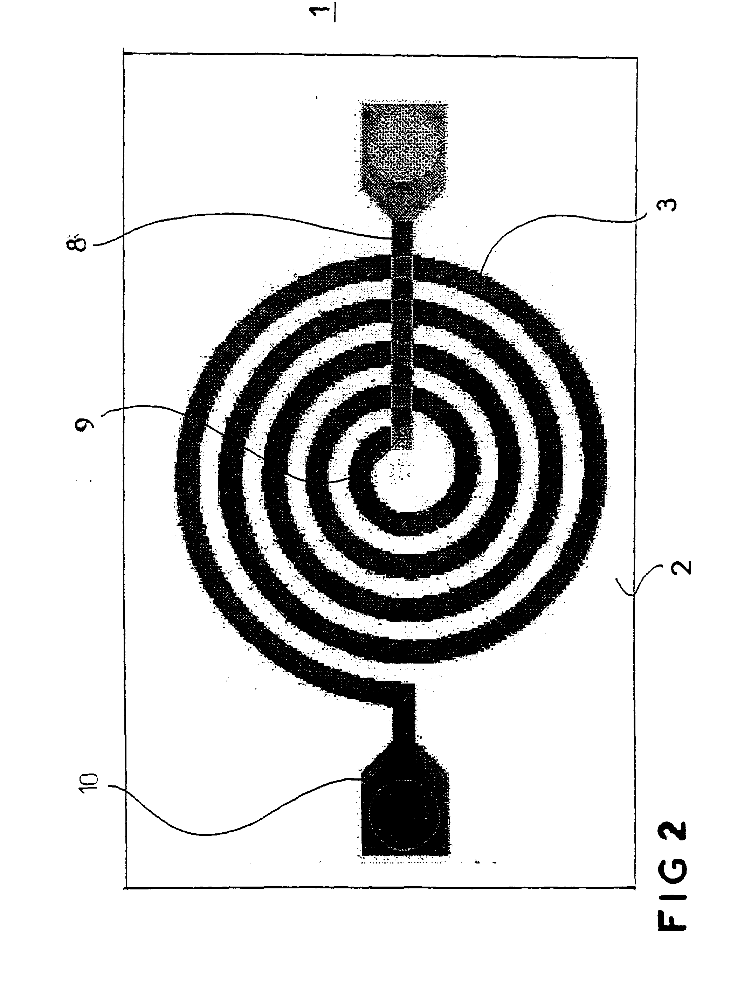

Conformément à une caractéristique de l'invention, ce composant inductif (1), comme illustré à la figure 2, comprend essentiellement une plaque (2) de substrat réalisée en quartz, sur laquelle est disposé un enroulement constitué d'un ruban métallique (3).

Ce ruban (3) est enroulé en spirale, de manière à former un bobinage inductif. La forme illustrée à la figure 2 est un enroulement à spirale circulaire, qui est la géométrie préférée, mais l'invention ne se limite pas à ce type d'enroulement et englobe d'autres enroulements en spirale dans lesquels le ruban est par exemple constitué d'une succession de segments rectilignes formant chacun avec le segment suivant un angle de 90° pour donner une forme générale carrée à l'enroulement. D'autres formes polygonales peuvent également être envisagées.

Selon une caractéristique importante de l'invention, le substrat utilisé est réalisé en quartz.

Selon une autre caractéristique importante de l'invention, le ruban formant l'inductance est en cuivre, et présente une épaisseur beaucoup plus importante que celle des rubans utilisés pour constituer les inductances intégrées existantes.

En effet, le ruban (3) présente une épaisseur (E₃) supérieure à 10 microns, et préférentiellement voisine de 30 microns, valeurs à comparer avec les 2 à 3 microns d'épaisseur des rubans d'aluminium des inductances existantes.

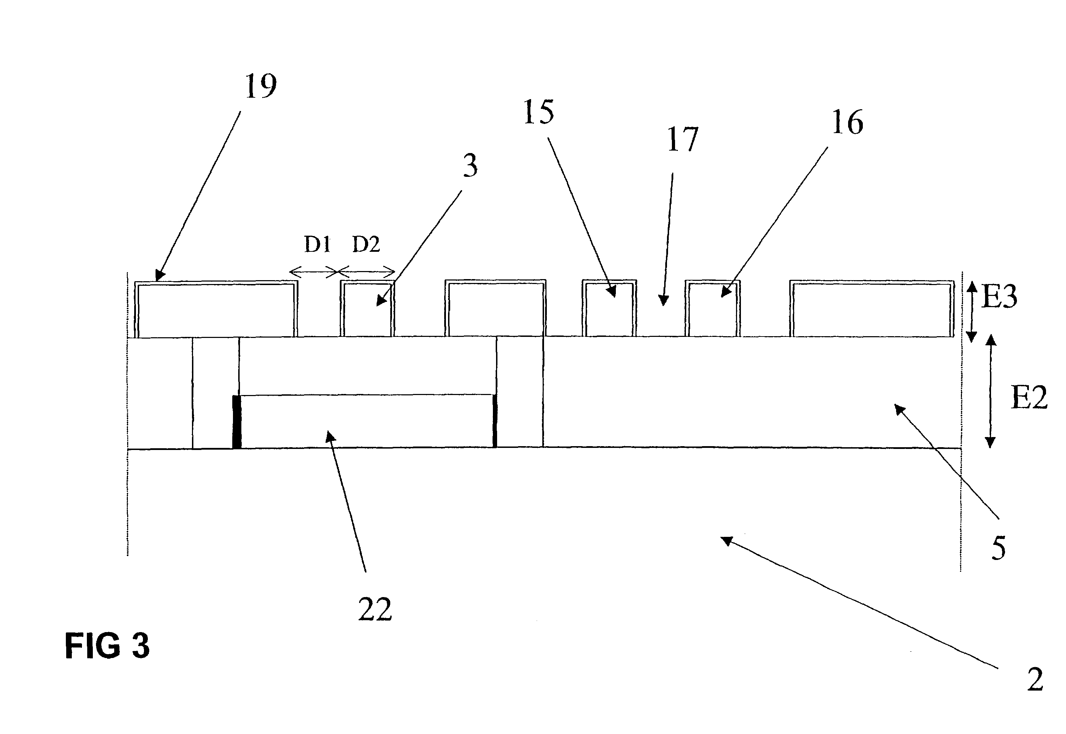

Plus précisément, et comme illustré à la figure 3, la couche de substrat en quartz est recouverte d'une couche de polyimide (5) interposée entre le substrat de quartz (2) et le ruban (3) formant inductance.

Cette couche de polyimide est notamment traversée par le segment (8) qui relie le centre (9) de la spirale, jusqu'à l'extrémité (10) du ruban qui forme une des deux bornes de connexion.

En pratique, l'épaisseur (E₂) de la couche de polyimide (5) est voisine de 35 microns. L'épaisseur de la couche de polyimide qui recouvre le segment (8) est comprise entre 4 et 6 microns.

Comme illustré à la figure 3, la largeur (D2) de chaque spire (10) est de l'ordre de 30 microns, tandis que la distance (D1) séparant les spires de cuivre (15) est de l'ordre de 30 microns.

En fonction de la valeur d'inductance recherchée, on réalise une spirale qui présente le nombre approprié de tours.

Comme déjà dit, selon une des caractéristiques de l'invention, le ruban de cuivre (3) est recouvert, sur ses faces en contact avec le milieu extérieur, d'une fine couche d'or (19), typiquement d'une épaisseur de 1000 à 2000 Å, et dont la fonction est d'assurer une protection du ruban de cuivre (3) contre les phénomènes d'oxydation, qui, comme on le sait, dégradent les propriétés conductrices du cuivre.

Selon une caractéristique de l'invention, l'espace (17) situé entre les spires (15, 16) du ruban est exempt de toute matière, et donc empli d'air. De la sorte, on diminue au maximum la capacité parasite existant entre spires (15, 16), ce qui permet le fonctionnement de l'inductance sur une gamme de fréquence plus élevée.

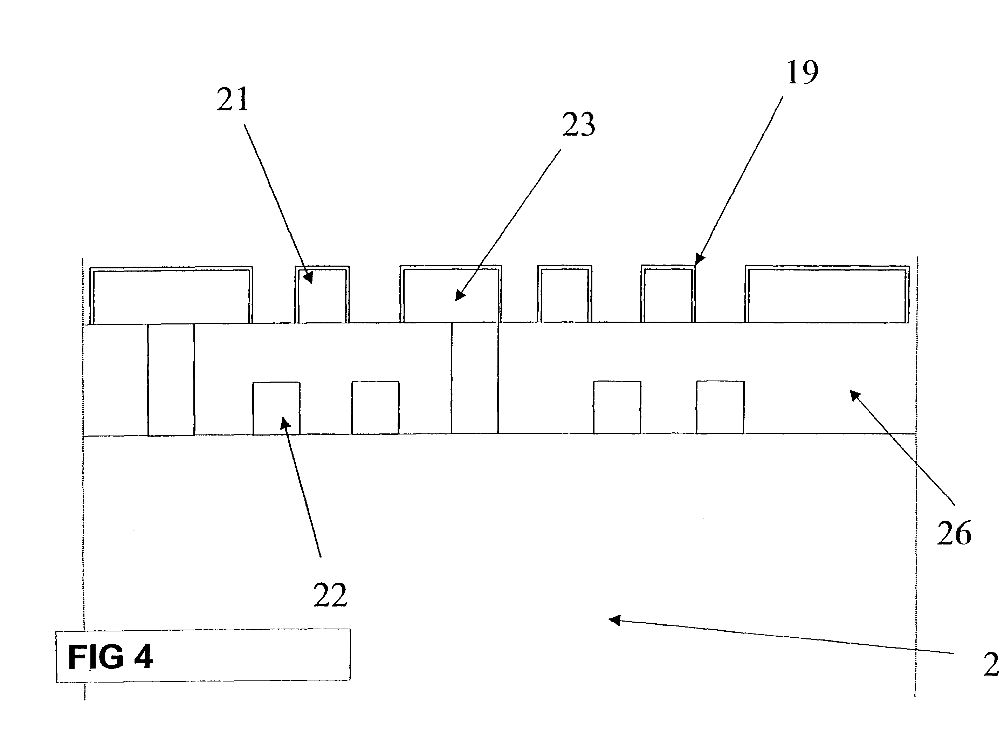

Dans les cas où une forte valeur d'inductance est recherchée, le ruban de cuivre est enroulé pour constituer deux spirales en série, comme illustré à la coupe de la figure 4.

Plus précisément, le ruban forme deux spirales planes (21, 22) disposées parallèlement l'une sur l'autre.

Ces deux spirales (20, 21) sont reliées en série au niveau de leur axe central commun (23), et tournent dans le même sens.

Ainsi, comme illustré à la figure 4, la spirale (22) disposée le plus près du substrat de quartz (2) est noyée dans la couche de polyimide (26), tandis que la spirale (21) en contact avec le milieu extérieur est, comme la spirale simple de la figure 3, recouverte d'une couche d'or (19), destinée à prévenir les risques d'oxydation.

La section des spires est identique sur les deux spirales. Dans le cas particulier où les spirales sont polygonales, avantageusement, les spires des deux spirales sont décalées transversalement pour ne pas être disposées les unes au dessus des autres, ce qui diminue la capacité parasite entre spires.

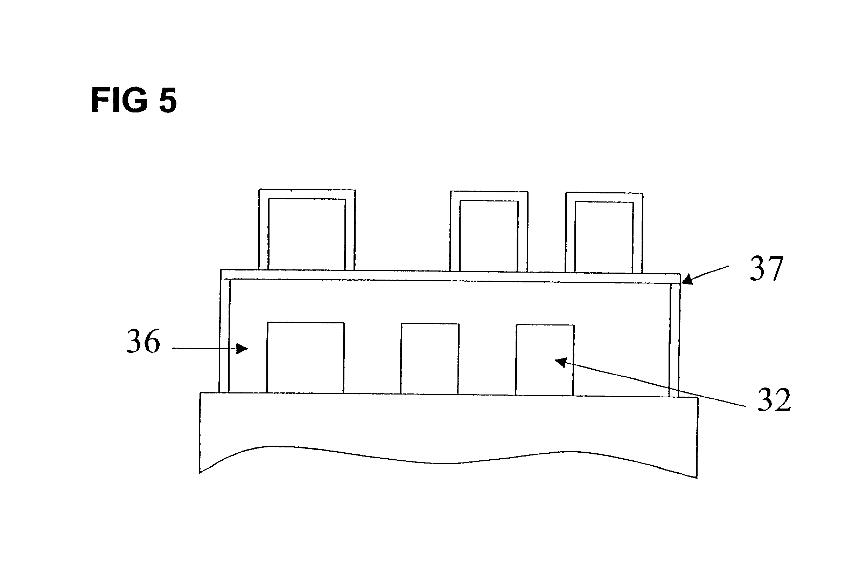

Dans une forme particulière illustrée à la figure 5, la couche de polyimide (36) à l'intérieur de laquelle est plongée la spirale inférieure (32), est elle-même recouverte d'une couche protectrice de silice (37), destinée à protéger la couche de polyimide (36) des agressions chimiques extérieures, et prolonger ainsi la durée de vie du composant inductif.

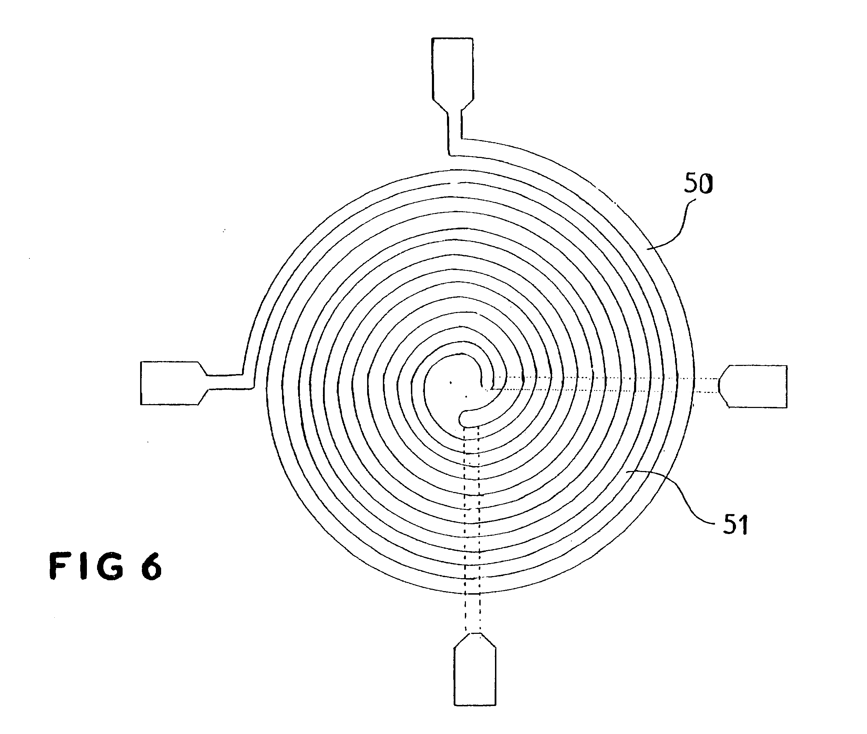

Le principe de l'invention permet également la réalisation de transformateurs intégrés, qui incluent conformément à la figure 6 au moins deux inductances (50, 51) réalisées par deux rubans indépendants, et enroulées en spirales imbriquées de telle sorte que ces inductances (50, 51) soient couplées.

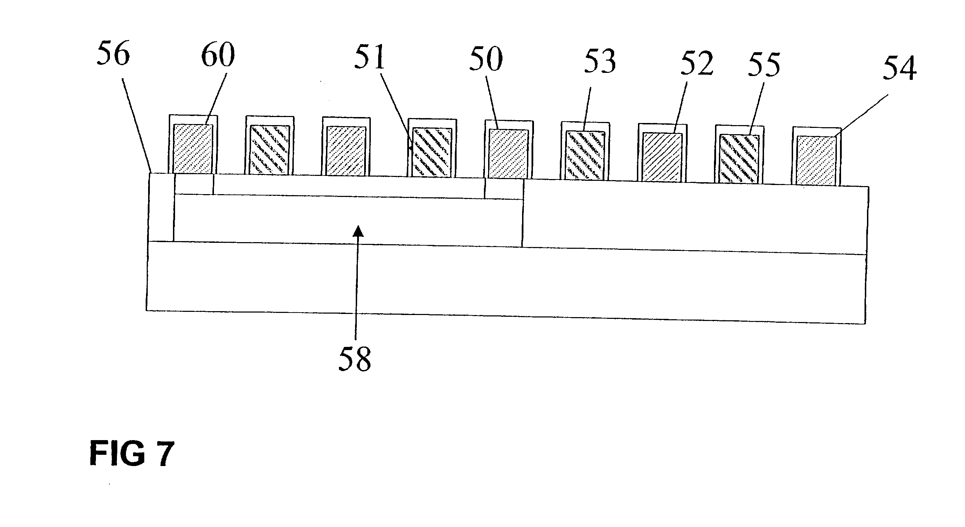

En pratique, comme illustré à la figure 7, les inductances (50, 51) sont enroulées de telle sorte que les spires (53, 55) d'une première spirale (51) sont intercalées entre les spires (52, 54) de l'autre spirale (50).

Comme déjà dit, le composant inductif conforme à l'invention est destiné à être incorporé dans un circuit radiofréquence, notamment incorporant des circuits intégrés.

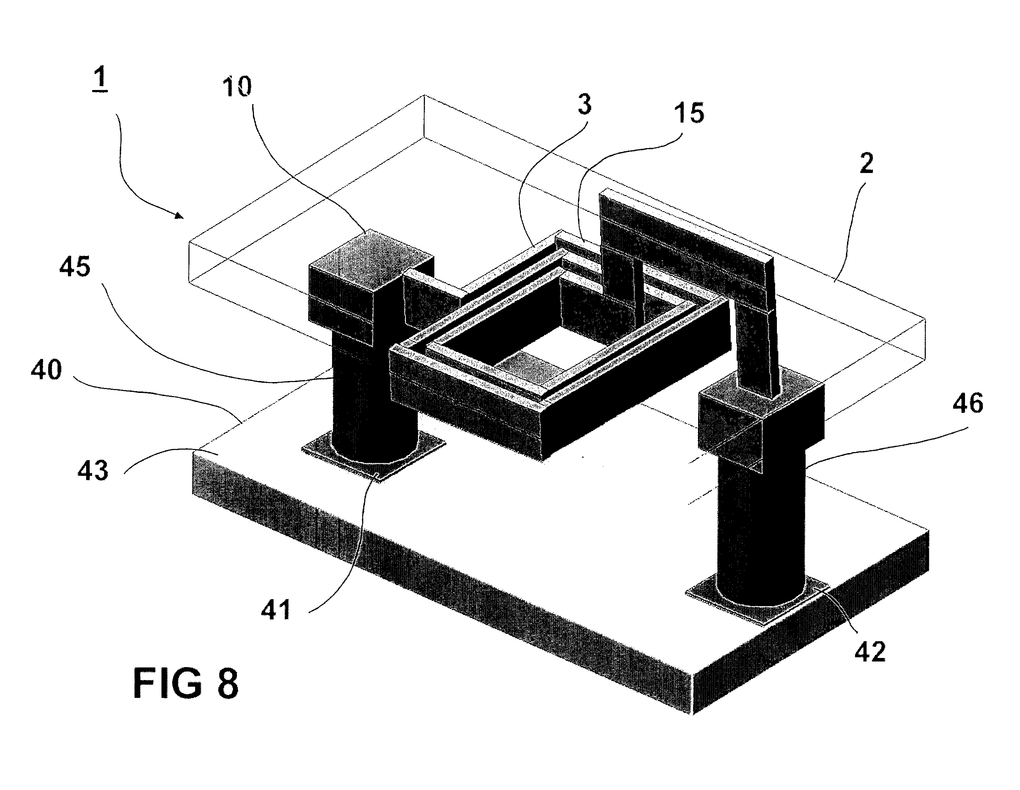

Une telle association est notamment illustrée schématiquement à la figure 8.

Ainsi, sur un circuit intégré (40) qui comprend des plots (41, 42) de connexion métalliques, ménagés à l'intérieur de la couche (43) de passivation du substrat semi-conducteur, on vient monter au moyen d'éléments entretoises (45, 46), généralement appelés "bumps", le composant inductif (1) précité selon une technique de montage communément appelée "flip-chip".

Sur la figure 8, le substrat de quartz (2) du composant inductif (1) a été rendu transparent pour laisse apparaître le ruban (3) formant inductance, qui est situé entre le circuit intégré (40) et le substrat (2) de quartz.

Selon une caractéristique de l'invention, ce montage s'effectue au moyen d'entretoises (45, 46) qui présentent une section cylindrique, destinée notamment à assurer une bonne stabilité mécanique du composant inductif (1) sur le circuit intégré (40).

En effet, on sait que les circuits radiofréquence doivent supporter des contraintes mécaniques de vibrations et de chocs particulièrement élevées.

Ainsi, par exemple dans l'application de l'invention aux téléphones portables, le matériel est soumis à des tests de chocs très rigoureux, pouvant atteindre plusieurs accélérations de la pesanteur. Il est donc essentiel que les composants montés par dessus les circuits intégrés ne présentent aucun risque de décrochement, ce qui aurait pour conséquence la mise hors service d'un appareil. Les contraintes de résistance aux vibrations sont également très sévères.

Ainsi, conformément à une caractéristique de l'invention, les éléments entretoises (45, 46) épousent une forme cylindrique particulièrement robuste. Le diamètre choisi pour de tels éléments entretoises cylindriques, est sensiblement voisin de la largeur d'un plot standard (41, 42) réalisé sur un circuit intégré, à savoir de l'ordre de 100 microns.

De la sorte, la stabilité mécanique est bien assurée, et la résistance électrique d'un tel élément entretoise (45, 46) est négligeable.

La hauteur de l'élément entretoise est choisie très voisine de la hauteur des spires (15) du ruban de cuivre (3), et est typiquement voisine de 30 microns. Le report sur le circuit intégré s'effectue par brasage.

Une hauteur de l'élément entretoise (45, 46) de 30 microns permet d'assurer un bon compromis entre la stabilité mécanique du composant inductif (1) sur le circuit intégré (40), tout en limitant au maximum les phénomènes de pertes électriques à l'intérieur du substrat semi-conducteur qu'engendrerait une trop forte proximité.

La réalisation du ruban de cuivre s'effectue selon un procédé incorporant une étape de dépôt par électrolyse. Ce dépôt par électrolyse s'effectue en croissance sur un tracé de base formé sur la face extérieure par une couche de croissance métallique recouverte d'une résine photosensible, qui est insolée et développée à la forme du motif.

On obtient des hauteurs de spires importantes, car les flancs de la résine thermosensible forment des cales qui occupent le volume qui constituera après croissance électrolytique du cuivre, l'espace entre spires.

On assure ainsi une canalisation latérale de la croissance électrolytique du cuivre permettant d'obtenir des spires de cuivre de section quasi rectangulaire, et de hauteur importante.

Après l'étape de réalisation des spires par croissance électrolytique, on élimine la matière ayant servi de cale pour obtenir, conformément à une caractéristique de l'invention, un espace entre spires empli d'air. On élimine également la couche de croissance métallique précitée.

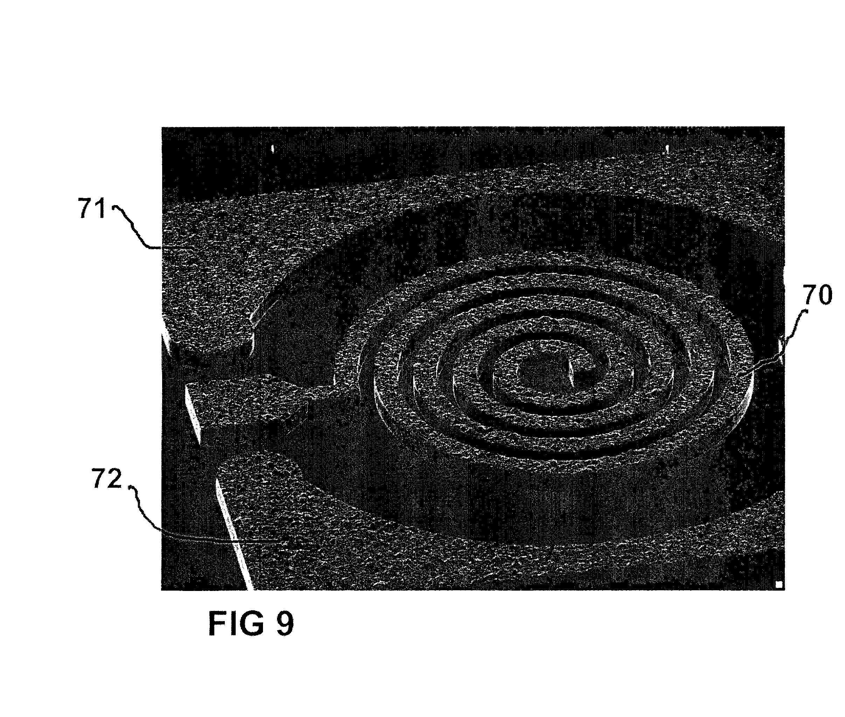

La figure 9 est une photographie prise au microscope électronique, qui montre un ruban (70) réalisé conformément au procédé précité. Il est entouré de deux pièces également métalliques (71, 72) qui ne jouent pas de rôle dans le comportement inductif du composant.

Il ressort de ce qui précède que le composant inductif, et le transformateur conforme à l'invention présente de multiples avantages, et notamment un excellent facteur de qualité, supérieur d'un facteur voisin de 10, à celui des inductances réalisées selon les techniques connues aujourd'hui. En outre, la gamme de fréquence de fonctionnement est élevée car la capacité parasite entre spires est particulièrement faible.

Par ailleurs, la résistance aux atmosphères chimiquement agressives est très bonne.

En association avec un circuit intégré, grâce aux éléments entretoises cylindriques conformes à l'invention, on obtient une très bonne stabilité mécanique et une résistance aux chocs et vibrations, tout en conservant d'excellentes caractéristiques électriques, notamment en terme de pertes électriques à l'intérieur du substrat semi-conducteur du circuit intégré.

### Applications industrielles

Les composants inductifs des transformateurs conformes à l'invention peuvent trouver de multiples applications, et notamment dans tous les circuits incluant des oscillateurs, des amplificateurs, des mixeurs ainsi que dans tout filtre actif ou passif. Les composants inductifs peuvent également être utilisés de façon isolée, en tant que composant discret, où leur grande précision est appréciable.

L'association avec des circuits intégrés trouve une application toute particulière dans les montages électroniques destinés au traitement des télécommunications, des micro-ondes et des radiofréquences.

## Revendications

1. Composant inductif (1), notamment destiné à être incorporé dans un circuit radiofréquence, comprenant:
- une couche de substrat (2) ;
- une inductance plane formée d'un ruban métallique (3) enroulé en spirale ;
caractérisé en ce que
- la couche de substrat (2) est réalisée en quartz ;
- le ruban métallique (3) est réalisé en cuivre, et présente une épaisseur (E₃) supérieure à 10 microns.

2. Composant selon la revendication 1, caractérisé en ce que le ruban métallique (3) présente une épaisseur (E₃) voisine de 30 microns.

3. Composant selon la revendication 1, caractérisé en ce qu'il comporte une couche de polyimide (5) interposée entre l'inductance (3) et le substrat de quartz (2), et à l'intérieur de laquelle chemine le segment (8) du ruban (3) reliant le centre (9) de la spirale, et une extrémité (10) du ruban (3) formant borne de connexion.

4. Composant selon la revendication 3, caractérisé en ce que le ruban métallique (3) est recouvert, sur ses faces autres que celles en contact avec le substrat (2) ou la couche de polyimide (5), d'une couche d'or (19).

5. Composant selon la revendication 1, caractérisé en ce que l'espace (17) entre les faces en regard de deux spires (15, 16) adjacentes est exempt de matière.

6. Composant selon la revendication 1, caractérisé en ce que le ruban (3) épouse une forme de spirale circulaire.

7. Composant selon la revendication 1, caractérisé en ce que le ruban (3) est enroulé en deux spirales (21, 22) en série, les deux spirales (21, 22) étant parallèles l'une par rapport à l'autre, la spirale (22) la plus proche du substrat (2) étant noyée dans une couche (26) de polyimide.

8. Composant selon la revendication 7, caractérisé en ce que la couche (26) de polyimide est recouverte d'une couche barrière en silice.

9. Composant selon la revendication 1, caractérisé en ce que les deux extrémités du ruban forment des bornes de connexion sur lesquelles sont montés des éléments entretoises (45, 46) présentant une hauteur voisine de l'épaisseur (E₃) du ruban métallique (3).

10. Transformateur intégré, notamment destiné à être incorporé dans un circuit radiofréquence comprenant:
- une couche de substrat (2) ;
- deux inductances planes (50, 51) formées par deux rubans métalliques enroulés en spirale, lesdites spirales s'enroulant l'une dans l'autre de sorte que les spires (53, 55) de l'une des inductances (51) sont positionnées entre les spires (52, 54) de l'autre inductance (50),
caractérisé en ce que :
- la couche de substrat (2) est réalisée en quartz ;
- les rubans métalliques sont réalisées en cuivre, et présentent une épaisseur supérieure à 10 microns ;

11. Transformateur intégré selon la revendication 10, caractérisé en ce que les rubans métalliques présentent une épaisseur voisine de 30 microns.

12. Transformateur intégré selon la revendication 10, caractérisé en ce qu'il comporte une couche de polyimide (56) interposée entre les inductances (50, 51) et le substrat (2) de quartz et à l'intérieur de laquelle cheminent les segments (58) des rubans reliant les centres des inductances (50, 51), et les extrémités des rubans formant borne de connexion.

13. Transformateur selon les revendications 10 et 12, caractérisé en ce que les rubans métalliques sont recouverts, sur leurs faces autres que celles en contact avec le substrat ou la couche de polyimide, d'une couche d'or.

14. Transformateur selon la revendication 10, caractérisé en ce que les rubans épousent des formes de spirales circulaires.

15. Transformateur selon la revendication 10, caractérisé en ce que l'espace entre les faces en regard des spires formant les rubans est exempt de matière.

16. Circuit intégré associé avec un composant inductif selon l'une des revendications 1 à 9, ou un transformateur intégré selon les revendications 10 à 15, caractérisé:
- en ce que le circuit intégré (40) inclut des plots de connexion (41, 42),
- et en ce que ledit composant inductif (1) ou ledit transformateur intégré est monté sur le circuit intégré (40) par l'intermédiaire d'éléments entretoises (45, 46) conducteurs assurant la connexion électrique entre lesdits plots de connexion (41, 42) du circuit intégré, et les bornes (10) de connexion du composant inductif ou du transformateur intégré, ledit composant inductif ou transformateur intégré étant orienté par rapport au circuit intégré de telle sorte que sa face incluant les inductances (3) est en regard du circuit intégré (40).

17. Circuit intégré selon la revendication 16, caractérisé en ce que les éléments d'entretoises (45, 46) ont une hauteur voisine de l'épaisseur du ruban (3) du composant inductif ou du transformateur intégré.

18. Circuit intégré selon la revendication 16, caractérisé en ce que les éléments d'entretoises (45, 46) ont épousent une forme cylindrique.

19. Circuit intégré selon la revendication 18, caractérisé en ce que les éléments d'entretoises (45, 46) ont un diamètre dont la valeur est voisine de trois fois celle de leur hauteur.
